Europäisches Patentamt

European Patent Office

Office européen des brevets

(19)

(11) **EP 0 418 421 B1**

(12) **EUROPÄISCHE PATENTSCHRIFT**

(45) Veröffentlichungstag und Bekanntmachung des Hinweises auf die Patenterteilung:
**12.08.1998 Patentblatt 1998/33**

(51) Int Cl.6: **H01L 29/732**, H01L 21/331

(21) Anmeldenummer: **89117579.6**

(22) Anmeldetag: **22.09.1989**

(54) **Verfahren zur Herstellung eines Bipolartransistors mit verminderter Basis/Kollektor-Kapazität**

Method of making a bipolar transistor having a reduced base-collector capacitance

Méthode de fabrication d'un transistor bipolaire ayant une capacité base-collecteur réduite

(84) Benannte Vertragsstaaten:
**DE FR GB IT NL**

(43) Veröffentlichungstag der Anmeldung:
**27.03.1991 Patentblatt 1991/13**

(73) Patentinhaber: **SIEMENS AKTIENGESELLSCHAFT**
**80333 München (DE)**

(72) Erfinder:
• **Meister, Thomas, Dr.**
**D-8028 Taufkirchen (DE)**

• **Meul, Hans Willi, Dr.**
**D-8206 Bruckmühl (DE)**

(56) Entgegenhaltungen:
EP-A- 35 111          EP-A- 118 102
EP-A- 189 136         US-A- 4 764 801

• D. Widmann et al., "Technologie hochintegrierter Schaltungen", Springer-Verlag, Berlin, 1988, S. 76-78

**Beschreibung**

Die Erfindung betrifft ein Verfahren zur Herstellung eines Bipolartransistors.

Auch mit zunehmender Miniaturisierung von Bipolartransistoren durch immer höher auflösende Phototechniken wird das "Power-Delay"-Produkt und die Schaltgeschwindigkeit bei niedrigen Strömen durch die externe Basis/Kollektor- und die parasitäre Kollektor/Substrat-Kapazität bestimmt. Bei der lateralen Skalierung der Transistorgröße muß daher angestrebt werden, die Beiträge der inaktiven Transistorgebiete zur Gesamtkapazität minimal zu halten. Verfahren, die mit selbstjustierenden Techniken die Kapazität der inaktiven Transistorgebiete reduzieren sollen, sind in der Literatur ausreichend bekannt.

Z. B. wurde von D. D. Tang et al, IEDM Technical Digest (1980), S. 58, ein selbstjustierter Bipolartransistor vorgeschlagen, bei dem der Basisanschluß sowohl zum Kollektor als auch zum Emitter selbstjustiert hergestellt wird. Der Kollektor wird in diesem Verfahren zwischen Isolationsstrukturen selektiv epitaktisch abgeschieden. Die darin implantierte, aktive Basis wird seitlich von einer aus Polysilizium bestehenden Basisanschlußzone kontaktiert. Dadurch kommt der Basisanschluß mit der aktiven Kollektorzone wenig in Berührung.

Der sogenannte SICOS-Prozeß (sidewall base contact in silicon), der z. B. aus T. Nakamura et al, IEEE Trans. Electron. Dev.,Bd. 29, (1982), S. 596 bekannt ist, baut auf einer Mesa-Ätzstruktur auf. Dabei liegt eine aus Polysilizium bestehende Basisanschlußzone kantengleich auf einer Siliziumoxidschicht. Die aktive Basis wird von der Seitenwand her kontaktiert.

Diese bekannten Transistoren haben jedoch Nachteile, die sich mit zunehmender Skalierung der Emitterbreite (d. h. abnehmender Emitterbreite) immer stärker auswirken:

Infolge der im Prozeß notwendigen Temperaturbelastungen diffundieren Dotierstoffe aus dem aus Polysilizium bestehenden Basisanschluß seitlich in die aktive Basis. Diese Ausdiffusion ist in einem gewissen Ausmaß erforderlich, um einen niedrigen Basisanschlußwiderstand zu erhalten (s. Goto, Journal de Physique, Colloque C4, supplément au n° 9, Tome 49, (1988), S. C4-471). Im Fall einer selektiven Epitaxieschicht, wie sie in dem aus D. D. Tang et al, IEDM Technical Digest (1980), S. 58 bekannten Transistor verwendet wird, entstehen am seitlichen Basisrand beim selektiven Auffüllen des Kollektorfensters Korngrenzen, die die Transistorfunktion beeinträchtigen oder ganz unmöglich machen. Die Funktion der von Tang et al vorgeschlagenen Transistorstruktur wird eventuell verbessert, falls eine beträchtliche Ausdiffusion von Dotierstoffen aus dem Basisanschluß erfolgt, so daß die Korngrenzen möglichst in inaktive Transistorgebiete verlegt werden. Der resultierende parasitäre Beitrag zur Basis/Kollektor-Kapazität wirkt sich mit abnehmender Emitterbreite immer stärker aus, da die räumliche Ausdehnung des Bereichs, in dem der Basisanschluß mit der aktiven Kollektorzone in Berührung kommt, sich mit abnehmender Emitterbreite nicht ändert.

Die laterale Ausdiffusion der Dotierstoffatome aus dem aus Polysilizium bestehenden Basisanschluß reduziert ferner die aktive Transistorfläche, so daß an den Rändern des Emitter/ Basis-Überganges zusätzliche neue parasitäre Transistorbereiche entstehen, die anteilig die Emitter/Basis-Kapazität vergrößern.

Aus US-A-4 764 801 ist ein vertikaler Bipolartransistor bekannt, der in einem Schichtaufbau mit alternierenden Schichten aus dielektrischem Material und polykristallinem Halbleitermaterial realisiert ist. Dazu wird in dem Schichtaufbau eine Öffnung erzeugt, die bis auf die Oberfläche eines unterhalb des Schichtaufbaus angeordneten Halbleitersubstrats reicht. Die polykristallinen Halbleiterschichten werden unter die dielektrischen Schichten rückgeätzt. Durch selektive Epitaxie wird die Öffnung mit Halbleitermaterial aufgefüllt. Die polykristallinen Halbleiterschichten dienen als Kollektoranschluß und als Basisanschluß. Der an den Basisanschluß angrenzende Teil des Halbleitergebietes wirkt als inaktiver Basisbereich.

Der Erfindung liegt die Aufgabe zugrunde, ein Verfahren zur Herstellung eines Bipolartransistors anzugeben, bei dem der Anteil des gesamten, elektrisch wirksamen Basisanschlußbereiches zur Basis-Kollektor-Kapazität minimiert ist, ohne daß dadurch andere parasitäre Kapazitäten im Transistor erzeugt werden.

Die Aufgabe wird erfindungsgemäß gelöst durch ein Verfahren nach Anspruch 1.

Die Isolationsstrukturen definieren in dem erfindungsgemäß hergestellten Bipolartransistor auf dem Emitter bzw. dem Kollektoranschluß jeweils Flächen, die vorzugsweise gleich groß sind und einander gegenüber liegen. Dadurch weist der erfindungsgemäße Bipolartransistor eine eindimensionale Transistorstruktur auf. In eindimensionalen Transistorstrukturen sind die parasitären Kapazitätsanteile minimiert.

Es liegt im Rahmen der Erfindung, daß die Basis des Bipolartransistors mit einem seitlichen Basisanschluß versehen ist. Dadurch ist die Basis seitlich kontaktiert. Der Basisanschluß umgibt die Basis ringförmig. Der Basisanschluß ist vollständig zwischen den den aktiven Transistorbereich definierenden Isolationsstrukturen angeordnet. Dadurch wird die Grenzfläche zwischen dem Basisanschluß und dem Kollektor minimiert. Diese Grenzfläche führt zu den störenden parasitären Basis-Kollektor-Kapazitäten. Da der Basisanschluß vollständig in Isolationsstrukturen vergraben ist, werden auch parasitäre Kapazitäten minimiert, die zum Beispiel auf eine Grenzfläche zwischen dem Basisanschluß und dem aktiven Emitter zurückzuführen wären.

Es liegt im Rahmen der Erfindung, daß ein $n^+$-dotierter Subkollektor, der unterhalb des Kollektors angeordnet ist, von einer vergrabenen, elektrisch leitfähigen Schicht (zum Beispiel $n^+$-Polysilizium, Silizid, Polizid, Wolfram) kontaktiert wird, die zum größten Teil über Isolationsmaterial verläuft und so vom Siliziummaterial mit dem entgegengesetzten Leitfähigkeitstyp vollständig dielektrisch isoliert ist. Dieser vergrabene Kollektoranschluß ist seitlich weiter über den Subkollektor ausgedehnt. Seitlich des aktiven Transistorbereichs trifft ein mit einer Metallisierung gefülltes Kontaktloch auf die vergrabene, leitfähige Schicht. Durch diese Art der Kontaktierung des Kollektors kann auf einen ausgedehnten Subkollektor verzichtet werden, der im Stand der Technik, meistens gemeinsam mit einer zweiten Siliziuminsel, zum Anschuß des Kollektors benötigt wird. Der Anschluß des Kollektors über die leitfähige, in Oxidbereichen vergrabene Schicht führt zu einer beträchtlichen Reduktion der parasitären Kollektor/Substrat-Kapazität und erlaubt einen sehr kompakten Aufbau des Transistors und damit eine Erhöhung der Packungsdichte in integrierten Schaltungen. Der Transistor ist geeignet für integrierte sogenannte BICMOS-Schaltungen, die sowohl Bipolarals auch CMOS-Transistoren enthalten.

Der gesamte Kollektoranschluß ist vom Siliziumsubstrat mit dem entgegengesetzten Leitfähigkeitstyp vollständig dielektrisch isoliert. Da außerdem die Kontaktfläche zwischen dem Subkollektor und dem Siliziumsubstrat minimal gehalten wird, resultiert eine Transistorstruktur mit einer ebenfalls vernachlässigbaren Kollektor/Substrat-Kapazität.

Der den Subkollektor seitlich überlappende Kollektoranschluß ist beispielsweise als Doppelschicht aus einer dotierten Polysiliziumschicht und einer metallhaltigen Schicht ausgebildet. Die metallhaltige Schicht besteht z. B. aus einem Metallsilizid. Der vergrabene Kollektoranschluß ist ringförmig um den Kollektor angeordnet. Er ist oberhalb des Subkollektors angeordnet. Der Subkollektor und der Kollektoranschluß stehen miteinander in Kontakt. Die Polysiliziumschicht und der Subkollektor sind von demselben Leitfähigkeitstyp wie der Kollektor, jedoch von höherer Leitfähigkeit als der Kollektor. Diese Ausführung des Kollektoranschlusses erlaubt einen sehr niederohmigen Kollektoranschluß. Dennoch wird die Kollektor Substrat-Kapazität sehr gering gehalten, da, wie oben schon erwähnt, auf eine zweite Siliziuminsel zum Anschluß des Kollektors verzichtet wird und der Kollektoranschluß vollständig vom Siliziummaterial mit dem entgegengesetzten Leitfähigkeitstyp dielektrisch isoliert ist.

Der entsprechende Transistor ist besonders geeignet für die Integration in BICMOS-Schaltungen. Bei der Herstellung einer solchen BICMOS-Schaltung können der vergrabene Kollektoranschluß und die Gatemetallisierungen aus dem gleichen Material bestehen und gleichzeitig hergestellt werden. Über dem vergrabenen Kollektoranschluß ist eine weitere Isolation vorgesehen, die in einer BICMOS-Schaltung zum Schutz der CMOS-Transistoren vor den zur Herstellung der Bipolartransistoren notwendigen Prozeßschritten einsetzbar ist. Da der Kollektor des Transistors durch selektive Epitaxie erfindungsgemäß hergestellt wird, läßt er sich mit wenig Aufwand in einen BICMOS-Prozeß integrieren, wobei die Bipolar-Komponenten unabhängig von den CMOS-Komponenten optimiert werden können.

Durch Verwendung der Spacertechnik zur Definition des Kollektorbereichs werden Kollektorweiten möglich, die die minimal von der Photolithographie auflösbaren Abstände um zweimal die Spacerbreite unterschreiten.

Beim selektiven Rückätzen der Spacer entsteht eine Stufe.

Der obere Teil der Stufe enthält nach einer möglichen Ausführungsform eine Polysiliziumschicht, die die selektiv abgeschiedene Basis seitlich kontaktiert. Anstelle der Polysiliziumschicht kann auch beispielsweise eine Silizidschicht verwendet werden. Die Polysiliziumschicht ist herstellungsgemäß und selbstjustiert so angeordnet, daß keine Grenzfläche zwischen dem Kollektor und der Polysiliziumschicht gegeben ist. Auf dem Kollektor wird die Basis durch selektive Epitaxie aufgewachsen, wobei im Bereich der Stufe inaktive Basisbereiche entstehen.

Nach Abdecken des Basisanschlusses durch eine weitere Spacertechnik wird der Emitter durch Ausdiffusion aus einer entsprechend dotierten weiteren Polysiliziumschicht erzeugt.

Das beschriebene, erfindungsgemäße Herstellungsverfahren für einen Bipolartransistor erfolgt selbstjustierend. Lediglich die Lage und Größe der ersten Öffnung werden photolithographisch definiert. Die weiteren Ortsdefinitionen mit Hilfe von Spacertechniken erfolgen selbstjustiert. In der Spacertechnik wird ausgenutzt, daß die Breite eines Spacers allein von der Dicke der abgeschiedenen Schicht bestimmt wird. Die Spacerbreite ist unabhängig von Justiertoleranzen und Auflösungsproblemen, wie sie in der Photolithographie auftreten.

Weitere Ausgestaltungen der Erfindung gehen aus den übrigen Ansprüchen hervor.

Im folgenden wird die Erfindung anhand eines Ausführungsbeispiels und der Figuren näher erläutert.

Fig. 1 zeigt einen erfindungsgemäß hergestellten Bipolartransistor.

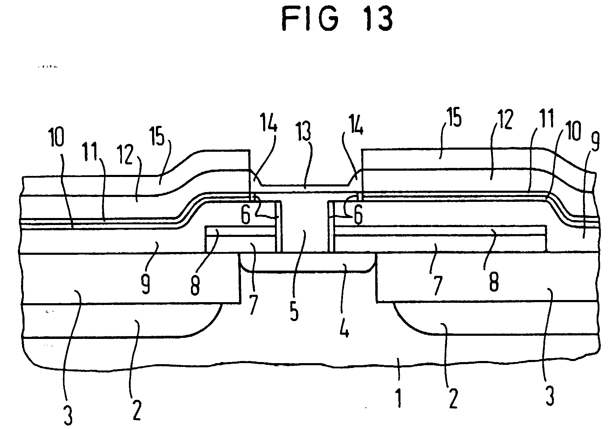

Fig. 2 bis Fig. 16 zeigen erfindungsgemäße Herstellungsschritte für einen Bipolartransistor.

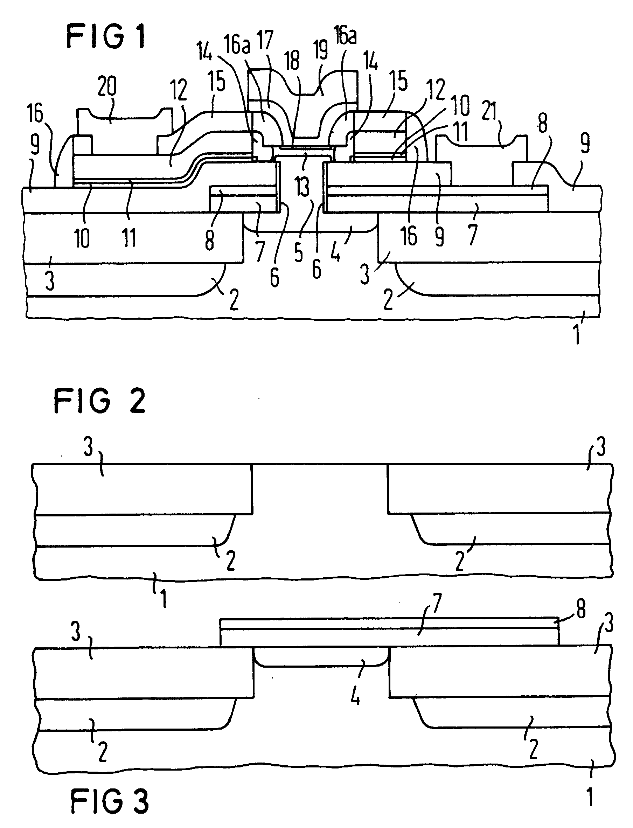

In Fig. 1 ist ein Substrat 1 dargestellt. Das Substrat 1 besteht z. B. aus schwach p-dotiertem (100) Czochralski-Silizium. In dem Substrat 1 sind Channel-stopper-Bereiche 2 angeordnet. Oberhalb der Channel-stopper-Bereiche 2 sind BOX-Isolationen 3, wie sie z. B. aus K. Kurosowa et al, IEDM Tech. Dig. (1981), S. 384, bekannt sind, angeordnet. Eine mögliche Alternative ist natürlich die Verwendung einer herkömmlichen LOCOS-Isolation. Zwischen den BOX-Isolationen 3 ist ein $n^+$-dotierter Subkollektor 4 angeordnet. Der Subkollektor 4 ist flacher als die BOX-Isolationen 3, die zur Isolation benachbarter Schaltungselemente im Substrat 1 dienen.

Auf dem Subkollektor 4 ist ein Kollektor 5 angeordnet. Der Kollektor 5 ist z. B. $n^-$-dotiert. Der Kollektor 5 ist von Flankenisolationen 6 umgeben. Die Flankenisolationen 6 bestehen z. B. aus einer dünnen Schicht Siliziumnitrid oder Siliziumoxid.

Zur Herstellung des Kollektoranschlusses ist eine erste Polysiliziumschicht 7 vorgesehen. Die erste Polysiliziumschicht 7 ist z. B. $n^+$-dotiert. Die erste Polysiliziumschicht 7 umgibt den Kollektor 5 außerhalb der Flankenisolationen 6 ringförmig. Die erste Polysiliziumschicht 7 ist an der Oberfläche des Subkollektors 4 und der Boxisolationen 3 angeordnet. Die erste Polysiliziumschicht 7 erstreckt sich mindestens an einer Seite des Kollektors 5 soweit auf die benachbarte Box-Isolation 3, daß dort eine Kontaktierung über ein Kontaktloch möglich ist.

Auf der ersten Polysiliziumschicht 7 ist eine leitfähige Schicht 8 angeordnet. Die leitfähige Schicht 8 besteht z. B. aus einem Metallsilizid und weist eine Dicke von 80 nm auf. Die leitfähige Schicht 8 bildet mit der ersten Polysiliziumschicht 7 senkrechte Flanken. Die leitfähige Schicht 8 verbessert die Leitfähigkeit der ersten Polysiliziumschicht 7. Die erste Polysiliziumschicht 7 und die leitfähige Schicht 8 bilden gemeinsam den Kollektoranschluß.

Die Oberfläche der Boxisolationen 3, der ersten Polysiliziumschicht 7 und der leitfähigen Schicht 8 sind mit einer ersten Oxidschicht 9 überdeckt. Die erste Oxidschicht 9 schließt in der Höhe mit den Flankenisolationen 6 ab. Die erste Oxidschicht 9 und die Flankenisolationen 6 begrenzen in seitlicher Richtung den aktiven Teil des Kollektors 5.

Auf der ersten Oxidschicht 9 sind eine erste Polysiliziumhilfsschicht 10 und eine erste Oxidhilfsschicht 11 angeordnet. Die erste Polysiliziumhilfsschicht 10 und die erste Oxidhilfsschicht 11 werden im Herstellungsverfahren benötigt und haben für den Transistor keine weitere Funktion.

Auf der ersten Oxidhilfsschicht 11 ist eine zweite Polysiliziumschicht 12 angeordnet. Die zweite Polysiliziumschicht 12 ist z. B. $p^+$-dotiert. Sie bildet den Basisanschluß. Die zweite Polysiliziumschicht 12 ist ringförmig um den aktiven Transistorbereich angeordnet.

Oberhalb des Kollektors 5 ist die Basis 13 angeordnet. Die Basis 13 ist z. B. p-dotiert. Sie besteht aus einkristallinem Silizium. Die Basis 13 ist umgeben von einem einkristallinen inaktiven Basisbereich 14. Der inaktive Basisbereich 14 ist $p^+$-dotiert. Der inaktive Basisbereich 14 stellt die Verbindung zwischen der zweiten Polysiliziumschicht 12 und der Basis 13 her.

Die zweite Polysiliziumschicht 12 und ein Teil der Oberfläche des inaktiven Basisbereichs 14 sind von einer zweiten Oxidschicht 15 bedeckt. Die Flanken der zweiten Polysiliziumschicht 12 und des inaktiven Basisbereichs 14 sind von Spacern 16 bedeckt.

Auf der zweiten Oxidschicht 15 und den Spacern 16, die über dem inaktiven Basisbereich 14 angeordnet sind, ist eine dritte Polysiliziumschicht 17 angeordnet.

Die dritte Polysiliziumschicht 17 ist z. B. $n^+$-dotiert. Auf der dritten Polysiliziumschicht 17 ist ein Emitterkontakt 19 angeordnet. In der zweiten Oxidschicht 15 ist ein Kontaktloch vorgesehen, das mit einem Basiskontakt 20 aufgefüllt ist. In der ersten Oxidschicht 9 ist ein Kontaktloch geöffnet, das mit einem Kollektorkontakt 21 aufgefüllt ist. Der Kollektorkontakt 21 führt auf die leitfähige Schicht 8. Der Basiskontakt 20 führt auf die zweite Polysiliziumschicht 12.

Die zweite Polysiliziumschicht 12, die den Basisanschluß bildet, und der einkristalline inaktive Basisbereich 14, der ebenfalls Bestandteil des Basisanschlusses ist, sind vollständig von Isolationsstrukturen umgeben: von oben durch die Spacer 16 und die zweite Oxidschicht 15, von unten durch die erste Oxidschicht 9. Der aktive Bereich des Kollektors 5 befindet sich innerhalb der Flankenisolationen 6. Außer oberhalb der Flankenisolation 6, in dem sich ein kleiner Bereich des Kollektors 5 infolge eines epitaktischen Überwachsens in die Basis 13 erstreckt, gibt es keine Berührungspunkte zwischen dem Basisanschluß und dem aktiven Kollektor. Die dritte Polysiliziumschicht 17, aus der der Emitter 18 durch Ausdiffusion erzeugt wird, wird auf die zweite Oxidschicht 15 und die Spacer 16 aufgebracht.

Im folgenden wird ein selbstjustierendes, erfindungsgemäßes Herstellverfahren für den Transistor beschrieben. Gleiche Merkmale werden mit gleichen Bezugszeichen bezeichnet. Dem Ausführungsbeispiel für das Herstellungsverfahren wird eine 0,4 μm-Photolithographie mit einer Justiertoleranz von ca. 0,133 μm zugrundegelegt.

In Fig. 2 ist das Substrat 1 dargestellt. In dem Substrat 1, das schwach p-dotiert ist und aus einkristallinem Silizium besteht, werden die Channel-stopper-Bereiche 2 und die Box-isolationen 3 z. B. nach dem aus K. Kurosowa et al, IEDM Tech. Dig. (1981), S. 384, bekannten Herstellungsverfahren erzeugt. Der Abstand der Kanten der Boxisolationen 3 beträgt 0,9 μm.

Es wird ganzflächig eine undotierte erste Polysiliziumschicht 7 mit einer Dicke von z. B. 80 nm abgeschieden (s. Fig. 3). Die erste Polysiliziumschicht 7 wird mit n-dotierenden Ionen implantiert. Auf der ersten Polysiliziumschicht 7 wird die leitfähige Schicht 8 aufgebracht. Die leitfähige Schicht 8 besteht z. B. aus einem Silizid und weist eine Dicke von z. B. 80 nm auf. Durch Ausdiffusion aus der ersten Polysiliziumschicht 7 in das Substrat zwischen den Boxisolationen 3 wird der Subkollektor 4 erzeugt. Die leitfähige Schicht 8 und die erste Polysiliziumschicht 7 werden so strukturiert, daß sie die Kanten der Boxisolationen 3 sicher überlappen. Mindestens auf einer Seite muß die Überlappung so groß sein, daß eine Kontaktlochätzung seitlich des Subkollektors 4 auf die leitfähige Schicht 8 möglich ist.

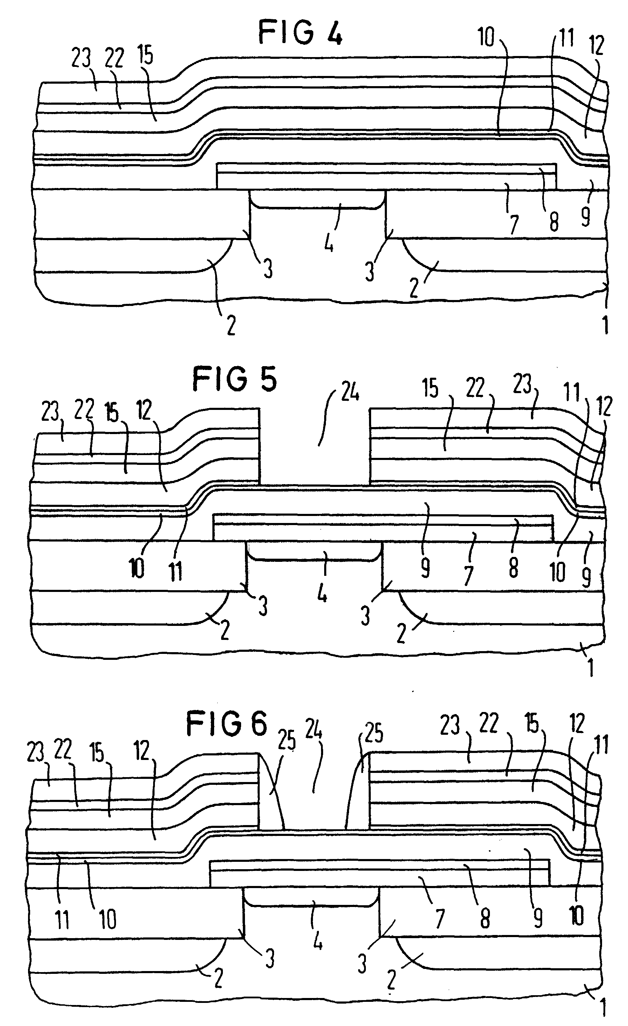

Auf die Oberfläche der sich ergebenden Struktur wird ganzflächig die erste Oxidschicht 9 aufgebracht (s. Fig. 4). Die erste Oxidschicht 9 wird in einer Dicke von z. B. 200 nm abgeschieden. Auf die erste Oxidschicht 9 wird die erste Polysiliziumhilfsschicht 10 aufgebracht.

Die erste Polysiliziumhilfsschicht 10 wird in einer Dicke von z. B. 30 nm aufgebracht. Sie ist dotiert oder undotiert. Auf die erste Polysiliziumhilfsschicht 10 wird die erste Oxidhilfsschicht 11 in einer Dicke von z. B. 20 nm aufgebracht. Auf die erste Oxidhilfsschicht 11 wird die zweite Polysilizumschicht 12 aufgebracht. Die zweite Polysiliziumschicht 12 weist eine Dicke von z. B. 150 nm auf. Die zweite Polysiliziumschicht 12 wird mit p-dotierenden Atomen implantiert. Auf der zweiten Polysiliziumschicht 12 wird die zweite Oxidschicht 15 ganzflächig in einer Dicke von z. B. 150 nm abgeschieden. Auf der zweiten Oxidschicht 15 wird eine zweite Polysiliziumhilfsschicht 22 in einer Dicke von z. B. 30 nm erzeugt. Auf der zweiten Polysiliziumhilfsschicht 22 wird eine zweite Oxidhilfsschicht 23 in einer Dicke von z. B. 80 nm erzeugt.

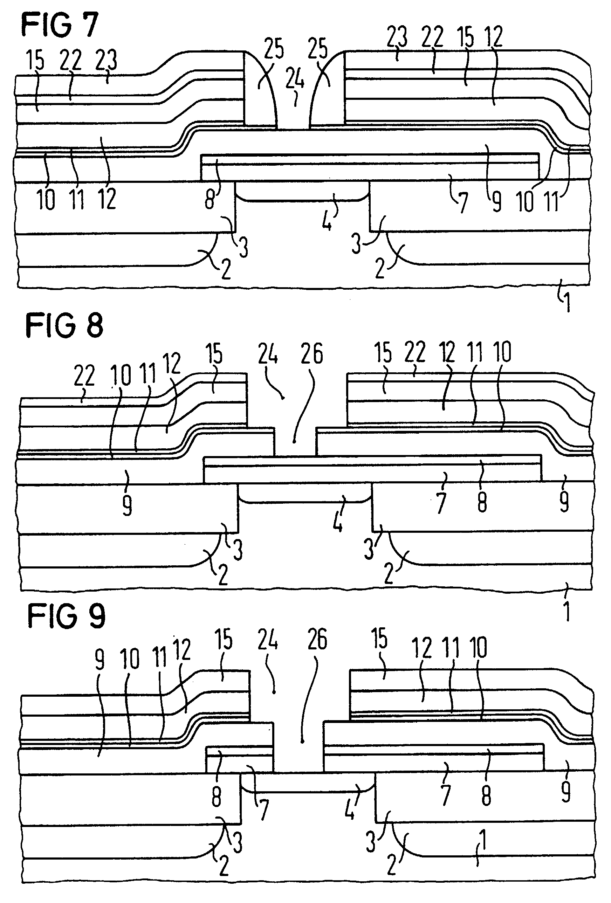

Nach einer Phototechnik werden die zweite Oxidhilfsschicht 23, die zweite Polysiliziumhilfsschicht 22, die zweite Oxidschicht 15, die zweite Polysiliziumschicht 12 und die erste Oxidhilfsschicht 11 mit Trockenätzschritten strukturiert, so daß eine erste Öffnung 24 entsteht. Die erste Öffnung 24 ist vollständig oberhalb des Subkollektors 4 angeordnet. Die erste Polysiliziumhilfsschicht 10 wirkt als Ätzstopp unter der ersten Oxidhilfsschicht 11 (s. Fig. 5).

Auf die zweite Oxidhilfsschicht 23 wird ganzflächig eine 150 nm dicke Oxidschicht abgeschieden. Diese wird anisotrop zurückgeätzt, so daß an den Seitenwänden der ersten Öffnung 24 erste Oxidspacer 25 entstehen (s. Fig. 6). Die ersten Oxidspacer 25 haben die Funktion, die Fläche, an der später die Basis 13 hergestellt wird, und die Fläche, an der später der Kollektor 5 hergestellt wird, selbstjustierend und zueinander gleich einzustellen.

Mit einem weiteren Trockenätzschritt wird am Boden der ersten Öffnung 24 die erste Polysiliziumhilfsschicht 10 entfernt (s. Fig. 7).

In die erste Oxidschicht 9 wird mit Hilfe eines selektiven Ätzschrittes eine zweite Öffnung 26 geätzt. Die selektive Ätzung entfernt das Siliziumoxid, greift jedoch Polysilizium und Metallsilizid Stoffe nicht oder kaum an. Als Ätzmittel ist z. B. $CHF_3 + O_2$ geeignet. Die zweite Öffnung 26 reicht bis auf die leitfähige Schicht 8, die wegen der Selektivität der Ätzung nicht angegriffen wird (s. Fig. 8). In diesem selektiven Ätzschritt werden gleichzeitig die zweite Oxidhilfsschicht 23 und die ersten Oxidspacer 25 entfernt. Dabei wirkt die zweite Polysiliziumhilfsschicht 22 als Ätzstopp unter der zweiten Oxidhilfsschicht 23.

Die Lage und die Ausmaße der zweiten Öffnung 26 sind durch die Form der ersten Oxidspacer 25 bestimmt. Die Breite der ersten Oxidspacer 25 ist über die Schichtdicke der Oxidschicht einstellbar, aus der die ersten Oxidspacer 25 durch anisotropes Rückätzen entstehen. Die Lage und die Abmessung der zweiten Öffnung 26 werden daher selbstjustierend, d. h. ohne Einsatz einer Phototechnik, festgelegt. Dabei kann die Weite der zweiten Öffnung kleiner als das Auflösungsvermögen der Lithographie sein.

Mit einem Trockenätzschritt wird am Boden der zweiten Öffnung 26 zunächst die leitfähige Schicht 8 und dann die darunterliegende erste Polysiliziumschicht 7 entfernt. Damit ist im Bereich der zweiten Öffnung 26 die Oberfläche des Subkollektors 4 freigelegt (s. Fig. 9). In diesem Trockenätzschritt wird gleichzeitig die zweite Polysiliziumhilfsschicht 22 sowie die freiliegenden Anteile der ersten Polysiliziumhilfsschicht 10 entfernt.

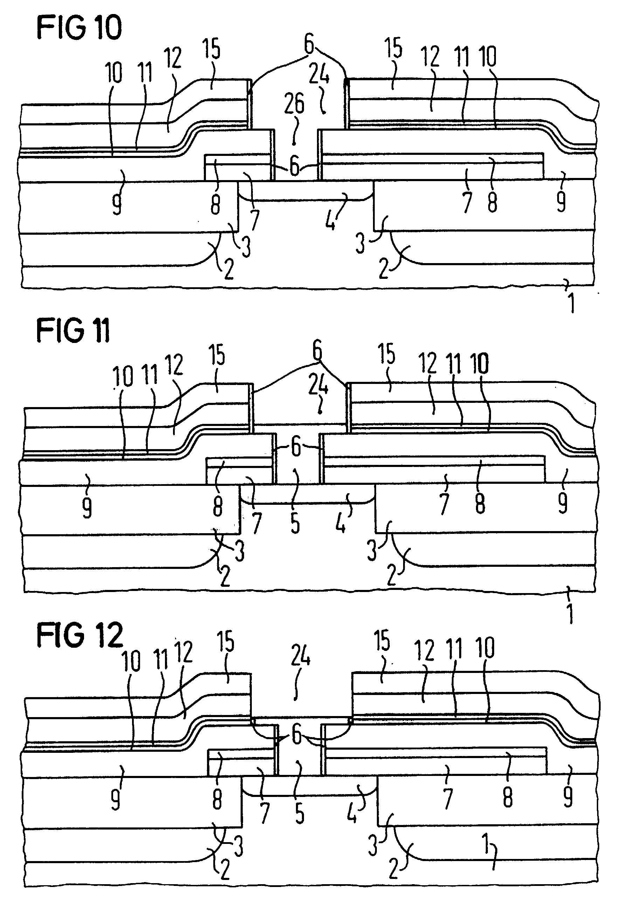

An den Wänden der ersten Öffnung 24 und der zweiten Öffnung 26 werden im folgenden Flankenisolationen 6 erzeugt (s. Fig. 10). Dazu wird ganzflächig eine dünnen Isolationsschicht aus z. B. Siliziumoxid oder Siliziumnitrid hergestellt, die durch anisotropes Ätzen auf der zweiten Oxidschicht 15, der ersten Oxidschicht 9 und der Oberfläche des vergrabenen Bereichs 4 wieder entfernt wird.

Die zweite Öffnung 26 wird mit n-leitendem Silizium mit einer Dotierung von $1 \times 10^{16}$ cm$^{-3}$ selektiv in einem Epitaxiereaktor aufgefüllt. Dadurch entsteht der Kollektor 5. Bei der selektiven Epitaxie wächst auf einer einkristallinen Unterlage, hier der freigelegten Oberfläche des Subkollektors 4, eine einkristalline Schicht auf. Die Flankenisolationen 6 verhindern dabei die Nukleation von Siliziumatomen an der ersten Polysiliziumschicht 7 und der zweiten Polysiliziumschicht 12. Steht für den Basisanschluß 12 und den aus der ersten Polysiliziumschicht 7 und der leitfähigen Schicht 8 bestehenden Kollektoranschluß ein geeignetes Material zur Verfügung, an dem keine Nukleation von Siliziumatomen während der selektiven Epitaxie stattfindet, kann auf diese Flankenisolationen verzichtet werden. Für das weitere Herstellverfahren ist es günstig, bei der selektiven Epitaxie ein geringes Überwachsen der Kanten der ersten Öffnung 24 vorzusehen.

Mit einer naßchemischen Ätzung wird der freiliegende Teil der Flankenisolationen 6 an den Wänden der ersten Öffnung 24 entfernt. Dadurch wird die zweite Polysiliziumschicht 12 im Bereich der ersten Öffnung 24 freigelegt (s. Fig. 12).

In die erste Öffnung 24 werden auf die Oberfläche des Kollektors 5 durch selektive Epitaxie in einem Epireaktor die aktive Basis 13 sowie inaktive Basisbereiche 14 abgeschieden (s. Fig. 13). Die Schichtdicke der abgeschiedenen Basis 13 beträgt z. B. 80 nm. Die Basis 13 ist p-dotiert mit einer Dotierung von $1 \times 10^{19}$ cm$^{-3}$. Da bei der selektiven Epitaxie zur Herstellung des Kollektors 5 die Kanten der ersten Öffnung 24 überwachsen wurden, erfolgt die selektive Epitaxie zur Herstellung der aktiven Basis 13 auf einer zusammenhängenden Kristallfläche. Dieses wirkt sich günstig auf die Kristallstruktur aus. Bei der selektiven Epitaxie findet auch eine Kristallisation ausgehend von den freiliegenden Flanken der zweiten Polysiliziumschicht 12 statt. In diesem Bereich ist mit Korngrenzen zu rechnen. Das wirkt sich jedoch nicht ungünstig auf den Betrieb des Transistors aus, da die Korngrenzen ausschließlich in den inaktiven Basisbereichen 14 liegen und später mit Spacern 16a abgedeckt werden.

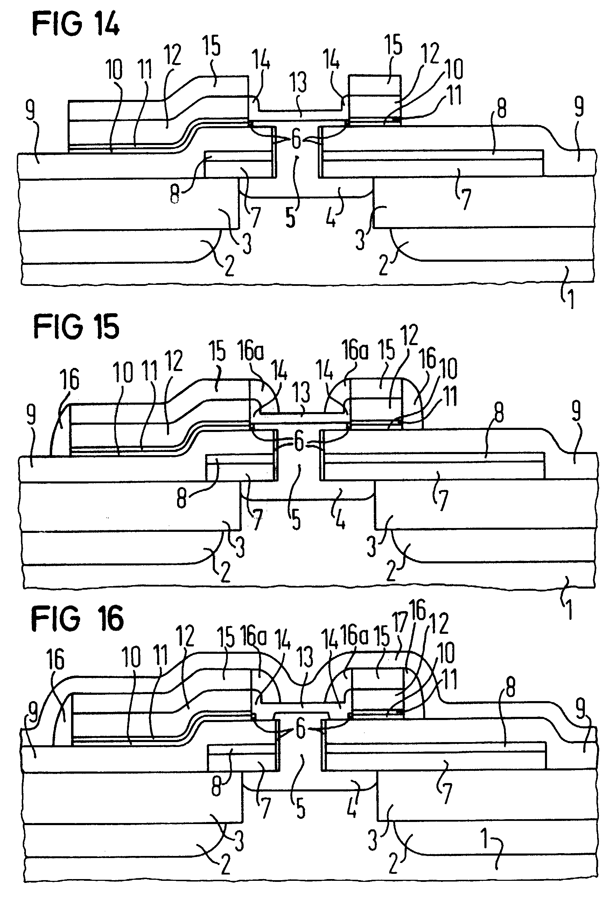

Nach einer Phototechnik werden die zweite Oxidschicht 15, die zweite Polysiliziumschicht 12, die erste Oxidhilfsschicht 11 und die erste Polysiliziumhilfsschicht 10 strukturiert. Die Strukturierung erfolgt so, daß mindestens an einer Seite des aktiven Transistorbereichs die zweite Polysiliziumschicht 12 weit genug auf die erste Oxidschicht 9 hinausreicht, daß hier eine Kontaktlochätzung möglich ist. (s. Fig. 14)

Zur Herstellung von Spacern 16 wird eine weitere Oxidschicht in einer Dicke von z. B. 150 nm abgeschieden und mit einem anisotropen Trockenätzschritt zurückgeätzt. Die Innenspacer 16a (s. Fig. 15) führen zu einer Selbstjustierung des Emitter/Basis-Komplexes. Sie verlegen eventuell am Basisrand entstandene Korngrenzen in inaktive Transistorgebiete. Außerdem liegen diese selbstjustierend, d. h. ohne Einsatz einer Phototechnik, hergestellte Innenspacer 16a vollständig im inaktiven Transistorgebiet. Sie verbrauchen keinen Platz von dem aktiven Transistorgebiet. Ihre Herstellung liefert daher keine zusätzlichen Beiträge zur Basis/Kollektor-Kapazität.

Auf die Oberfläche der Struktur wird ganzflächig eine dritte Polysiliziumschicht 17 aufgebracht (s. Fig. 16). Die Schichtdicke der aufgebrachten dritten Polysiliziumschicht 17 beträgt z. B. 100 nm. Es folgt eine Implantation mit n-dotierenden Ionen in die dritte Polysiliziumschicht 17. Anschließend wird die dritte Polysiliziumschicht 17 mit einer unkritischen Phototechnik so strukturiert, daß sie die aktive Basis 13 und die inaktiven Basisbereiche 14 überlappt. Der Emitter 18 wird durch Ausdiffusion aus der dritten Polysiliziumschicht 17 erzeugt. Der Emitter 18 wird z. B. 30 nm in das einkristalline Silizium ausgetrieben.

Nach einer Phototechnik werden die Kontaktlöcher für den Basisanschluß in der zweiten Oxidschicht 15 und für den Kollektoranschluß in der ersten Oxidschicht 9 geöffnet. Es folgt die Metallisierung des Emitterkontaktes 19, des Basiskontaktes 20 und des Kollektorkontaktes 21. Die sich ergebende fertige Transistorstruktur entspricht der in Fig. 1 gezeigten.

Das geschilderte Herstellverfahren für einen npn-Bipolartransistor läßt sich ohne weiteres auf den Fall eines pnp-Bipolartransistors übertragen.

Eine Variante des Herstellverfahrens ergibt sich dadurch, daß die einkristallinen Bereiche für die Basis und den Kollektor in einem selektiven Epitaxieschritt hergestellt werden und die Basis anschließend durch Ionenimplantation erzeugt wird.

Da die aktiven Transistorgebiete in diesem erfindungsgemäßen Verfahren ausschließlich in Bereichen liegen, die durch selektive Epitaxie hergestellt wurden, eignet sich dieses Verfahren zur Integration in einen BICMOS-Prozeß. In einem solchen BICMOS-Prozeß erfolgt die Herstellung der ersten Polysiliziumschicht 7 und der leitfähigen Schicht 8 nach der Kanalimplantation. Es ist vorteilhaft für die Gatemetallisierung ebenfalls diese beiden Schichten vorzusehen. Dadurch kann eine Maske eingespart werden. Mit der ersten Oxidschicht 9 werden in einem BICMOS-Prozeß die schon fertig prozessierten CMOS-Transistoren abgedeckt.

Die Integration des erfindungsgemäßen Herstellverfahrens in ein BICMOS-Herstellverfahren erlaubt eine unabhängige Optimierung der Bipolar- sowie der CMOS-Komponenten.

## Patentansprüche

1. Verfahren zur Herstellung eines Bipolartransistors mit einem aktiven Transistorbereich, der einen Emitter, eine Basis und einen Kollektor aufweist, einem Kollektoranschluß und Isolationsstrukturen, die den Stromfluß durch den aktiven Transistorbereich begrenzen, mit folgenden Schritten:

   a) auf einem Substrat (1) werden eine erste Schicht (11, 12, 15, 22, 23) und eine zweite Schicht (9, 10) erzeugt, wobei die erste Schicht oberhalb der zweiten Schicht angeordnet ist und wobei die zweite Schicht mindestens eine Isolationsschicht (9) enthält,

   b) in der ersten Schicht (11, 12, 15, 22, 23) wird photolithographisch eine erste Öffnung (24) erzeugt, die die Oberfläche der zweiten Schicht (9, 10) freilegt,

   c) an den Flanken der ersten Öffnung (24) werden Spacer (25) erzeugt,

   d) beim selektiven Rückätzen der Spacer (25) wird in der zweiten Schicht (9, 10) eine zweite Öffnung (26) geätzt, die einen Bereich (4) des Substrats für den Kollektor (5) definiert, der von Isolationsbereichen (3) umgeben ist,

   e) der Kollektor (5) wird durch selektive Epitaxie auf dem von Isolationen (3) umgebenen Bereich (4) des Substrats (1) hergestellt.

2. Verfahren nach Anspruch 1,
   **gekennzeichnet durch** folgende Schritte:

   a) auf dem Kollektor (5) wird in der ersten Öffnung (24) durch selektive Epitaxie die Basis (13, 14) hergestellt, die einen aktiven Basisbereich (13) und inaktive Basisbereiche (14) aufweist,

   b) die erste Schicht (11, 12, 15, 22, 23) enthält mindestens eine niederohmige, leitfähige Schicht (12), die über den inaktiven Basisbereichen einen seitlichen Basisanschluß zur Basis (13) bildet.

**3.** Verfahren nach Anspruch 2, **gekennzeichnet durch** folgende Schritte:

a) nach Herstellung des aktiven Basisbereichs (13) und der inaktiven Basisbereiche (14) wird auf der ersten Schicht (11, 12, 15, 22, 23) eine Isolationsschicht erzeugt und anisotrop geätzt, so daß an den Flanken der ersten Öffnung (24) weitere Spacer (16a) entstehen,

b) nach Erzeugen einer entsprechend dotierten Polysiliziumschicht (17), die die Basis (13, 14) überlappt, wird der Emitter (18) durch Ausdiffusion aus der entsprechend dotierten Polysiliziumschicht (17) in die Basis (13, 14) erzeugt.

**Claims**

**1.** Method for the production of a bipolar transistor having an active transistor region, which has an emitter, a base and a collector, a collector terminal and insulation structures which limit the flow of current through the active transistor region, having the following steps:

a) a first layer (11, 12, 15, 22, 23) and a second layer (9, 10) are produced on a substrate (1), the first layer being arranged above the second layer and the second layer containing at least one insulation layer (9),
b) a first opening (24) is produced by photolithography in the first layer (11, 12, 15, 22, 23), which opening uncovers the surface of the second layer (9, 10),
c) spacers (25) are produced on the flanks of the first opening (24),
d) upon selectively etching back the spacers (25), a second opening (26) is etched in the second layer (9, 10), which opening defines a region (4) of the substrate for the collector (5) which is surrounded by insulation regions (3),
e) the collector (5) is produced by means of selective epitaxy on that region (4) of the substrate (1) which is surrounded by insulations (3).

**2.** Method according to Claim 1, characterized by the following steps:

a) on the collector (5) the base (13, 14) is produced in the first opening (24) by means of selective epitaxy, which base has an active base region (13) and inactive base regions (14),
b) the first layer (11, 12, 15, 22, 23) contains at least one low-resistance, conductive layer (12), which forms, by way of the inactive base regions, a lateral base terminal to the base (13).

**3.** Method according to Claim 2, characterized by the following steps:

a) after the production of the active base region (13) and of the inactive base regions (14), an insulation layer is produced on the first layer (11, 12, 15, 22, 23) and is anisotropically etched, thereby producing further spacers (16a) on the flanks of the first opening (24),
b) after the production of an appropriately doped polysilicon layer (17), which overlaps the base (13, 14), the emitter (18) is produced by outdiffusion from the appropriately doped polysilicon layer (17) into the base (13, 14).

**Revendications**

**1.** Méthode de fabrication d'un transistor bipolaire constitué d'une zone active de transistors dotée d'un émetteur, d'une base et d'un collecteur, d'une connexion de collecteur et de structures isolantes qui limitent le flux de courant par la zone active du transistor, et comportant les étapes suivantes:

a) une première couche (11, 12, 15, 22, 23) et une seconde couche (9, 10) sont produites sur un substrat (1), la première couche étant disposée au-dessus de la seconde couche et la seconde couche contenant au moins une couche isolante (9),

b) une première ouverture (24), qui dégage la surface de la seconde couche (9, 10) est pratiquée par photolithographie dans la première couche (11, 12, 15, 22, 23),

c) des entretoises (25) sont produites sur les flancs de la première ouverture (24),

d) une seconde ouverture (26), qui définit une zone (4) du substrat pour le collecteur (5), entourée de zones d'isolation (3), est gravée dans la seconde couche (9, 10) lors de la gravure sélective en retrait des entretoises (25),

e) le collecteur (5) est fabriqué par épitaxie sélective sur la zone (4) du substrat (1) entourée d'isolations (3).

**2.** Méthode selon la revendication 1, **caractérisée par** les étapes suivantes:

a) la base (13, 14), qui présente une zone de base active (13) et une zone de base inactive (14) est fabriquée sur le collecteur (5) dans la première ouverture (24) par épitaxie sélective,

b) la première couche (11, 12, 15, 22, 23) contient au moins une couche (12) conductrice à basse impédance, qui forme une connexion de base latérale par rapport à la base (13) au-dessus des zones inactives de la base.

3.   Méthode selon la revendication 2, **caractérisée par** les étapes suivantes:

a) après la fabrication de la zone de base active (13) et des zones de base inactives (14) une couche isolante est produite sur la première couche (11, 12, 15, 22, 23) et gravée par anisotropie, si bien que des entretoises (16a) supplémentaires sont formées aux flancs de la première ouverture (24),

b) après la fabrication d'une couche de polysilicium (17) dopée en conséquence, qui recouvre la base (13, 14), l'émetteur (18) est produit dans la base (13, 14) par exodiffusion à partir de la couche de polysilicium (17) dopée en conséquence.

FIG 1

FIG 2

FIG 3

## FIG 4

## FIG 5

## FIG 6

## FIG 7

## FIG 8

## FIG 9

**FIG 10**

**FIG 11**

**FIG 12**

# FIG 13

**FIG 14**

**FIG 15**

**FIG 16**